# FASCICULE DE BREVET EUROPEEN

(11) **EP 0 298 829 B1**
(45) Date de publication et mention de la délivrance du brevet: **27.11.1996**
(21) Numéro de dépôt: 88401626.2
(22) Date de dépôt: 27.06.1988
(51) Int. Cl.: H01L 21/768, H01L 21/28, H01L 21/268, H01L 23/52

(54) **Procédé de commande de l'état de conduction d'un transistor MOS**
Verfahren zum Einstellen des Leitungszustandes eines MOS-Transistors
Process to control the conduction state of a MOS transistor

(30) Priorité: 02.07.1987 FR 8709381
(43) Date de publication de la demande: 11.01.1989
(73) Titulaire: BULL S.A., 78430 Louveciennes (FR)
(72) Inventeur: Boudou, Alain, F-75016 Paris (FR); Bonnal, Marie-Françoise, F-75016 Paris (FR); Rouillon-Martin, Martine, F-75016 Paris (FR)
(74) Mandataire: Denis, Hervé

(56) Documents cités:
- EP-A- 0 139 923
- EP-A- 0 252 814
- US-A- 4 387 503
- PATENT ABSTRACTS OF JAPAN, vol. 10, no. 205 (E-420)[2261], 17 juillet 1986, page 40 E 420 & JP-A-61 46 045
- IEEE TRANSACTIONS ON MAGNETICS, vol. SC20, no. 1, février 1985, pages 333-342, IEEE, New York, US; I.-C. Chen et al.: "Electrical breakdown in thin gate and tunneling oxides"
- IBM TECHNICAL DISCLOSURE BULLETIN, vol. 19, no. 8, janvier 1977, pages 3089-3090, New York, US; L. EWALD et al.: "Fusible link device"
- B.Spinks "Introduction to Integrated Circuit Layout", 1985 by Prentice-Hall, Englewood Cliffs, New Jersey 07632, pages 24 à 38
- IEEE Journal of Solid State Circuits, vol.SC-10, n 4, août 1975, pages 219 à 228
- Adir Bar-Lev "Semiconductors and Electronic Devices", deuxième édition, 1984, Prentice Hall International, Englewood Cliffs, NJ, pages 244 à 250
- S.M.Sze "VLSI TECHNOLOGY", deuxième édition, 1988, McGraw-Hill Book Company, New York, pages 472 à 483 et 513
- S.M.Sze "VLSI TECHNOLOGY" International Student Edition, 1984, McGraw-Hill Book Company, New York, pages 461 à 478
- JOURNAL OF APPLIED PHYSICS, vol. 47, n 5, mai 1976, pages 2120 à 2128

## Description

L'invention se rapporte à un procédé de commande de l'état de conduction d'un transistor MOS selon la première partie de la Revendication 1, connu du brevet US-A-4 387 503.

L'invention s'applique en général à la fabrication et à la conception des circuits qui sont intégrés dans le substrat semiconducteur monocristallin d'une puce et qui sont élaborés à partir de transistors à effet de champ du type MOS (Métal Oxyde Semiconducteur). L'invention s'applique avantageusement à la fabrication et à la conception de puces de grande taille et à très haute densité d'intégration, dites puces VLSI (Very Large Scale Integration chips) et notamment les puces incluant une mémoire morte programmable (Programmable Read-Only Memory).

La technique actuelle de fabrication et de conception des circuits intégrés de haute densité tente d'appliquer à grande échelle le laser pour modifier les circuits de ces puces. La modification des circuits intervient naturellement lorsque la puce est ou inclut une mémoire morte programmable. La programmation par laser sert alors à déterminer l'état de conduction des cellules de la mémoire. D'autre part, une modification des circuits de la puce est faite actuellement pour corriger certains défauts de connexion. D'une manière générale, la programmation par laser du fonctionnement des circuits intégrés d'une puce a de nombreuses applications et présente de nombreux avantages.

Un circuit intégré est essentiellement un substrat semiconducteur incorporant des régions dopées pour la constitution des composants électroniques et portant un réseau d'interconnexion de ces composants. Un transistor MOS est formé d'une grille qui est isolée du substrat par une couche diélectrique mince et qui a des parties latérales recouvrant respectivement sur une distance d les régions de source et de drain, comme cela est illustré dans l'article de Adir Bar-Lev "Semiconductors and Electronic Devices", deuxième édition, 1984, Prentice Hall International, Englewood, NJ, pages 244 à 250. Le réseau d'interconnexion repose sur le substrat par l'intermédiaire d'une couche diélectrique de dioxyde de silicium (SiO2) formée par croissance du matériau du substrat. La couche diélectrique est généralement mince au-dessus des régions dopées, de l'ordre de quelques dizaines de nanomètres, et épaisse entre ces régions (de plusieurs centaines de nanomètres). Le réseau d'interconnexion se compose couramment de plusieurs couches conductrices séparées par des couches d'isolation et reliées entre elles en certains points par des piliers (vias) traversant les couches d'isolation. Chaque couche conductrice se compose de nombreux conducteurs parallèles entre eux dans une direction orthogonale aux conducteurs d'une couche conductrice voisine. Des conducteurs de la couche inférieure sont connectés aux régions correspondantes du substrat par l'intermédiaire d'ouvertures ménagées dans la couche diélectrique mince qui recouvre ces régions.

La fabrication de circuits intégrés de très haute densité sur des puces de grande taille ne fournit actuellement qu'un faible pourcentage de puces sans défaut. Des défauts peuvent résider aussi bien dans le substrat semiconducteur que dans le réseau d'interconnexion formé au-dessus du substrat pour relier les composants de la puce. Plusieurs procédés de correction de défauts existent pour accroître le pourcentage des puces utilisables. Ces procédés de correction utilisent la reconfiguration des circuits ou la redondance de blocs fonctionnels. La reconfiguration consiste à modifier le câblage ou la fonction d'un circuit défectueux, tandis que la redondance consiste à substituer à un bloc défaillant un bloc homologue spécialement prévu pour la correction.

La reconfiguration et la redondance se font par l'intermédiaire d'un câblage additionnel conçu pour être connecté au câblage défectueux selon un progamme prédéterminé de connexions. Plus précisémment, la conception des circuits intégrés dans une puce prévoit que des conducteurs originaux de certains blocs ou éléments fonctionnels de la puce coopèrent avec des conducteurs de substitution du circuit de correction correspondant. Les conducteurs originaux et de substitution peuvent être des fils du réseau d'interconnexion ou des régions dopées du substrat. La correction consiste à inhiber les blocs ou éléments fonctionnels défectueux et à relier leurs conducteurs originaux aux conducteurs de substitution correspondants.

Plusieurs procédés de programmation, notamment pour mémoires mortes ou pour la correction de circuits, sont actuellement appliqués. Cependant, ces procédés évitent de recourir à la commande de la conduction d'un dispositif de liaison à transistor(s) pour relier un conducteur à un autre conducteur. En effet, le dispositif de polarisation et de commande du ou des transistors de liaison conduirait à un dispositif de liaison complexe, de relativement grande surface et coûteux. Compte tenu du grand nombre de liaisons à prévoir sur une puce de circuits à très haute densité d'intégration et de grande taille, la surface et le coût de l'ensemble des dispositifs de liaison seraient prohibitifs.

Par conséquent, les procédés de programmation tendent à utiliser au maximum les liaisons programmables par faisceau laser. Ces liaisons sont faites entre deux conducteurs superposés et isolés entre eux par une couche isolante. La conception des circuits intégrés consiste donc à superposer, par croisement notamment, un conducteur original avec le conducteur de substitution correspondant pour la correction des circuits, ou les deux conducteurs de ligne et colonne d'une mémoire morte programmable. Cependant, la connexion classique par laser dans les zones de superposition des deux conducteurs exige que le conducteur supérieur soit placé au niveau supérieur du réseau d'interconnexion. Cette contrainte aboutit à une grande complication du câblage et à un encombrement indésirable des canaux prévus pour les interconnexions du réseau. Il en est de même pour isoler, par coupure par laser, les blocs et éléments fonctionnels défectueux.

Il est donc souhaitable que la programmation fasse intervenir des dispositifs de liaison à transistors dont la commande par laser serait simple, l'encombrement faible et le coût minimal. En effet, ces dispositifs de liaison sont formés au niveau du substrat et pourraient être disposés de façon que les liaisons soient les plus courtes possible. Ces dispositifs de liaison permettraient ainsi de réduire l'encombrement du réseau d'interconnexion et faciliteraient sa conception.

Le brevet US-A-4387503 révèle un procédé de programmation par laser d'un circuit intégré, consistant à faire conduire un transistor MOS en formant une connexion électrique définitive par laser dans la couche diélectrique mince séparant une partie latérale de la grille et la région de drain sous-jacente. Le mode de connexion par laser n'est pas décrit et se réfère donc aux modes connus. Par exemple, la connexion par laser d'un conducteur à une région dopée du substrat est connue de l'article de Kuhn et al dans IEEE Journal of Solid-State Circuits, vol. SC-10, n° 4, août 1975, pages 219 à 228 et intitulé "Experimental Study of Laser Formed Connections for LSI Wafer Personalization". Cette connexion est faite de façon classique par la formation d'un cratère au moyen d'un faisceau de forte énergie. Elle ne peut se faire que par impact direct du faisceau laser sur le conducteur. En outre, le diamètre du cratère est relativement grand, de 2 µm au niveau de la connexion entre le conducteur et la région, et de 4 µm au sommet du cratère. Par conséquent, ce cratère ne peut pas se faire trop près du bord du conducteur. Si une partie du faisceau impacte en même temps la région, la forte puissance du faisceau endommagerait gravement la région.

Le document Patent Abstracts of Japan, vol. 10, n° 205 (E-420) [2261] 17 juillet 1986, page 40 E 420 ; JP-A-6 146 045 décrit la programmation d'un fusible en utilisant un autre procédé de connexion par laser. Le fusible est formé de la grille isolée du canal d'un transistor MOS ayant ses électrodes de source, de drain et de substrat au même potentiel. Le transistor est recouvert d'une couche de passivation. La mise en court-circuit de la grille avec le canal est faite en projetant le faisceau laser, au travers de la couche de passivation, au milieu de la grille silicium polycristallin pour faire fondre cette grille et percer la couche d'isolation de grille. A cause de la fusion de la grille, le faisceau ne pourrait pas déborder de la grille car il ferait aussi fondre la région adjacente du substrat de silicium et endommagerait aussi gravement le fonctionnement de cette région. D'autre part, ce procédé ne se rapporte pas à la commande de l'état de conduction d'un transistor MOS par l'intermédiaire de ses régions de source et de drain.

D'autre part, il est connu du document publié par S. M. Sze, "VLSI Technology" International Student Edition, 1984, McGraw-Hill International Book Company, pages 461-478 de commander l'état de conduction d'un transistor MOS en formant une connexion définitive par laser entre une région de source ou de drain et un élément en silicium polycristallin recouvrant en partie la région et connecté à la grille. Le mode de connexion par laser n'est pas explicité et se réfère donc au mode classique décrit par exemple dans l'article précité de Kuhn et al. Il en découle donc les mêmes inconvénients précités.

L'invention permet de commander de façon simple l'état de conduction d'un transistor MOS. Cette commande peut ne faire intervenir aucun élément additionnel au transistor et résout donc le problème de l'encombrement. En outre, la commande peut se faire après, la fabrication de la puce, c'est-à-dire après dépôt du réseau d'interconnexion et de la couche de passivation. De surcroît, la commande selon l'invention peut ne laisser pratiquement aucune trace visible au microscope optique de la modification de l'état de conduction du transistor MOS.

Le procédé conforme à l'invention de commande de l'état de conduction d'un transistor MOS est défini par la revendication 1.

Les caractéristiques et avantages de l'invention ressortiront de la description qui suit, donnée à titre d'exemple et faite en référence aux dessins annexés.

Dans les dessins :
- la figure 1 est une vue en coupe transversale partielle à l'aplomb d'un transistor MOS d'un circuit intégré illustrant l'invention ;
- la figure 2 est une vue schématique du transistor MOS représenté sur la figure 1 ;
- la figure 3 est une vue de détail agrandi du transistor représenté sur la figure 1 et illustre un mode de réalisation d'une connexion conforme à l'invention ; et
- la figure 4 est une vue de dessus d'un transistor MOS et illustre une variante du procédé utile à la compréhension de l'invention.

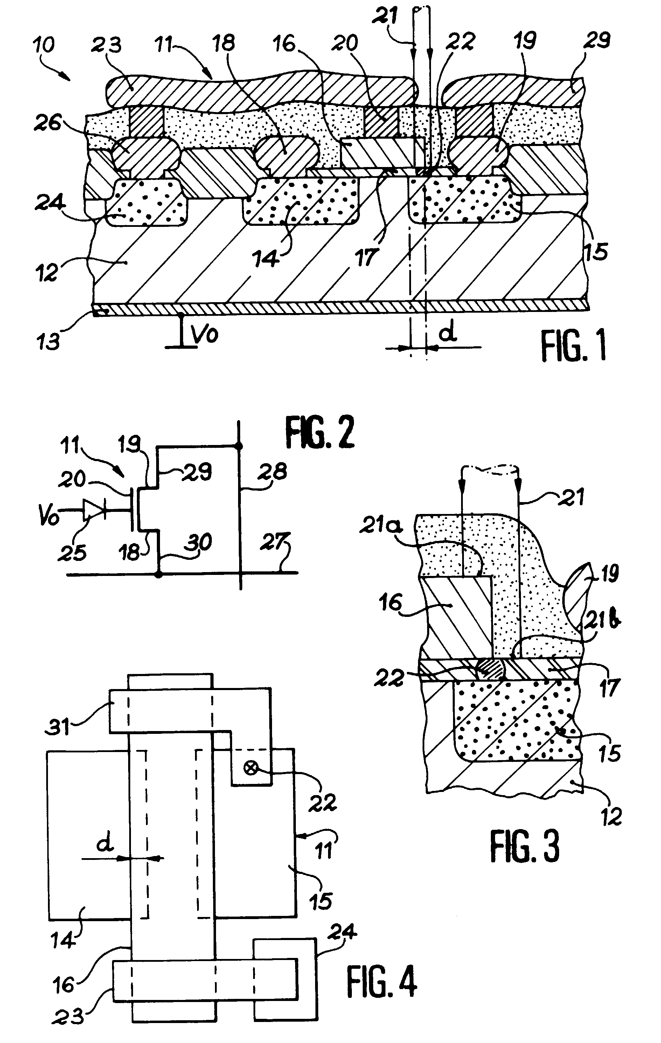

La figure 1 illustre en coupe transversale partielle un circuit intégré (10) conforme à l'invention, appelé simplement puce. La coupe est faite au niveau d'un transistor MOS (11) monté de la façon schématisée dans la figure 2. Dans la figure 1 comme dans les figures 3 et 4, les proportions réelles des longueurs n'ont pas été respectées pour la clarté des dessins et seront rectifiées à l'évidence par l'homme du métier. Le transistor (11) est formé sur une face du substrat semiconducteur (12) de la puce (10). On supposera que le substrat (12) est fait de silicium monocristallin de type P. L'autre face du substrat est recouverte par une électrode de substrat (13) mise à un potentiel de substrat Vo. Le transistor (11) se compose d'une région de source (14), d'une région de drain (15) et d'une grille (16). Les régions de source et de drain (14, 15) sont alors de type N+ et sont formées sous une couche diélectrique mince (17), ordinairement en dioxyde de silicium (SiO2) obtenu par croissance du substrat (12). La couche diélectrique (17) est ouverte au niveau des régions de source et de drain (14, 15) pour la formation des électrodes respectives de source (18) et de drain (19). La grille (16) est formée au-dessus de la couche diélectrique mince (17), entre les régions de source et de drain (14, 15). Ordinairement, la diffusion des dopants dans les régions de source et de drain (14, 15) lors du recuit fait que ces régions débordent sous la grille d'une distance d, comme illustré. La grille peut être métallique, ou en silicium polycristallin (polysilicium) fortement dopé, ou en un alliage des deux. Elle entre en contact avec une partie métallique qui constitue l'électrode de grille (20).

L'invention consiste à commander de manière définitive l'état de conduction du transistor MOS (11), en formant entre la grille (16) et la région de source (14) ou de drain (15) une liaison électrique incluant une connexion par laser. Dans l'exemple de la figure 1, un faisceau laser (21) est dirigé perpendiculairement au substrat (12) sur l'un des bords de la grille (16) qui recouvre sur la distance d les régions de source et de drain (14, 15). La connexion illustrée (22) est faite entre la grille (16) et la région de drain (15). La connexion (22) crée un court-circuit ou une liaison électrique de faible résistance entre la grille (16) et la région de drain (15). Le transistor MOS (11) est ainsi placé définitivement dans un état positif de conduction dès l'application des potentiels adéquats sur les électrodes (18, 19 et 20) du transistor (11). L'état négatif de conduction (blocage) du transistor (11) est déterminé définitivement en placant la connexion par laser (22) entre la grille (16) et la région de source (14).

La connexion (22) formée par le faisceau laser (21), mais faite de manière classique, telle que celle décrite par exemple dans l'article de Platakis intitulé "Mechanism of laser-induced metal-semiconductor electrical connections in MOS structures" et publié dans le "Journal of Applied Physics", Vol. 47, No. 5, May 1976, a cependant l'inconvénient d'utiliser un faisceau laser de forte énergie et de former un cratère susceptible de perturber le fonctionnement du transistor. Il a aussi pour inconvénient d'exiger que la connexion se fasse avant la formation de toute couche électriquement conductrice ou isolante susceptible de recouvrir le conducteur supérieur à connecter, c'est-à-dire ici la grille (16). Autrement dit, ce procédé de connexion selon l'état de la technique doit se faire, dans le cas présent, avant la formation du réseau d'interconnexion.

Parmi les procédés pouvant être appliqués, celui qui convient le mieux est le procédé selon l'invention. Selon ce procédé, le faisceau (21) est appliqué pour chevaucher le bord de la grille (16) et la région de source (14) ou la région de drain (15) du transistor (11). La figure 3 est une vue de détail agrandi de la figure 1 au niveau de la grille (16) et de la région de drain (15) pour la formation de la connexion (22) selon ce procédé d'application du faisceau laser (21). Ainsi, on voit que le faisceau laser (21) se partage en une partie (21a) sur le bord de la grille (16) et en une partie (21b) sur la couche diélectrique mince (17) recouvrant la région de drain (15). Selon ce procédé, la puissance du faisceau laser, son diamètre, le nombre et la durée des impulsions sont déterminés de façon à créer dans la couche diélectrique mince (17) des défauts définitifs, constitutifs d'une faible résistance électrique. Cette connexion offre de nombreux avantages. D'abord elle se fait avec un faisceau laser (21) de faible énergie. Ensuite la connexion (22) se produit seulement au niveau de la couche diélectrique mince (17). On suppose que la faible énergie du faisceau laser (21) suffit pour créer dans la couche mince (17) des défauts suffisants pour obtenir définitivement une connexion (22) efficace et fiable. Il s'avère en effet que cette connexion est pratiquement invisible au microscope optique et peut donc préserver le secret d'informations contenues dans la puce, notamment dans des transistors. En outre, grâce à la faible puissance requise du faisceau laser, la connexion (22) peut être faite en présence du réseau d'interconnexion, et même de la couche de passivation destinée à recouvrir ce réseau pour la protection physique, électrique et chimique des circuits de la puce.

L'expérience suivante illustre de façon typique ce procédé. Dans le transistor (11), les régions (14) et (15) avaient 0,4 micromètre de profondeur, la grille (16) était faite de polysilicium fortement dopé sur une épaisseur de 0,5 micromètre, la couche isolante qui recouvrait la grille faisait approximativement 1 micromètre d'épaisseur, et la couche mince de dioxyde de silicium (17) avait 70 nanomètres d'épaisseur. Le faisceau (21) avait un diamètre de 5 micromètres et une puissance de 0,76 Watt. L'application d'une seule impulsion de une milliseconde a suffit pour créer la connexion (22), dont la valeur mesurée de résistance était de l'ordre de 350 ohms. Les diverses expériences faites dans diverses conditions ont montré que ce procédé pouvait s'appliquer avec des grilles métalliques également, et que la résistance de la connexion (22) se situait entre 100 ohms et quelques kiloohms et plus particulièrement entre 300 ohms et 3 kiloohms. Ces valeurs dépendent des divers paramètres utilisés concernant le faisceau laser et les éléments de structure du transistor (11) impliqué.

Les figures 1 et 2 illustrent également un mode d'utilisation préféré d'un transistor (11) destiné à être utilisé conformément à l'invention qui vient d'être exposée. L 'électrode de grille (20) est reliée par un conducteur (23) à une région (24) indépendante du transistor (20), de type N+. La région (24) illustrée est isolée et a un potentiel flottant. Avantageusement, elle forme avec le substrat (12) une diode (25). L'anode de cette diode est formée par le substrat (12) et l'électrode d'anode est formée par l'électrode de substrat (13). La cathode de la diode (25) est constituée par la région (24) et l'électrode de cathode (26) est la partie d'extrémité du conducteur (23). Ainsi, en appliquant la masse (0 volt) sur l'électrode de source (18) et un potentiel de drain adéquat sur l'électrode (19), le transistor (11) pourvu de sa connexion (22) au niveau de la région de drain (15) est placé dans son état positif de conduction. Son courant de grille est constitué par le courant de conduction inverse de la diode (25) (courant de fuite de la diode) suffisant pour polariser la jonction de la diode (région 24/substrat 12) et la grille (16) par l'intermédiaire du conducteur (23).

Ce mode de réalisation de polarisation d'un transistor (11) conforme à 1 'invention est très avantageux. Un seul transistor suffit. La diode (25) peut être faite à proximité du transistor (11), de sorte que l'ensemble est simple et très compact. En outre, ce montage est peu coûteux. La région (24) est faite de la même manière que les régions de source et de drain (14, 15), et la connexion (22) peut être faite simplement.

Les figures 1 et 2 servent aussi à illustrer divers exemples d'application du transistor (11) et de sa diode (25) à la liaison d'un conducteur (27) avec un conducteur associé (28). L'électrode de drain (19) est reliée par un conducteur (29) au conducteur (28), tandis que l'électrode de source (18) est reliée au conducteur (27) par un conducteur (30). Les conducteurs (27) et (28) reçoivent à leurs extrémités des tensions adéquates pour polariser le transistor (11). Selon un exemple d'application possible, le conducteur (27) est le conducteur original d'un bloc ou élément fonctionnel défaillant et le conducteur (28) est le conducteur de substitution disposé dans le cadre de la redondance. Autrement, pour la reconfiguration d'un bloc ou élément fonctionnel défectueux, l'invention peut être appliquée à la modification de l'état de portes logiques, d'une manière évidente pour l'homme du métier. Selon un autre exemple, les conducteurs (27) et (28) constituent respectivement les fils de ligne et de colonne d'une mémoire morte programmable dont chaque cellule inclut le transistor (11) éventuellement associé à la diode (25). En effet, la diode (25) pourrait être remplacée par un dispositif de polarisation quelconque.

La figure 4 illustre une variante de réalisation de la liaison électrique utilisée, utile à la compréhension de l'invention pour relier la grille (16) à la région de source (14) ou de drain (15) d'un transistor MOS (11). Les éléments similaires à ceux des figures précédentes portent les mêmes chiffres de référence.

Le transistor (11) de la figure 4 est illustré par une vue de dessus. Pour des raisons de commodité, cette vue a été faite en l'absence des conducteurs non concernés par l'invention dans le réseau 5 d'interconnexion du circuit intégré (10). Ainsi, les régions de source et de drain (14, 15 ) sont, dans l'exemple illustré, des régions rectangulaires. La grille (16) a la forme d'une bande. La vue en coupe de ce transistor correspond à la figure 1. Cependant, selon une variante de réalisation conforme à l'invention, la liaison entre la grille (16) et la région de source (14) ou de drain (15) est faite par un conducteur (31) reliant la grille à la région de source (14) ou de drain (15). Le conducteur (31) illustré relie la grille (16) à la région de drain (15).

Le conducteur (31) peut être une extension de la grille (16) ou peut être fait en un matériau différent. La connexion par laser (22) peut être faite au niveau de la région de drain (15) ou au niveau de la superposition du conducteur (31) avec la grille (16). Cette variante est préférable lorsque la liaison directe, par la simple connexion (22) telle qu'illustrée dans la figure 1, ne peut pas être faite ou serait dommageable pour le fonctionnement du transistor. La variante représentée sur la figure 4 peut être imposée lorsque l'on veut utiliser la connexion par laser selon le procédé décrit en référence à la figure 3. En effet, il s'avère que la connexion (22) selon ce procédé est impossible si la grille (16) est faite d'un matériau semiconducteur dopé d'un autre type que celui des régions de source et de drain (14, 15). Ce peut être le cas par exemple dans les circuits CMOS. La variante représentée sur la figure 4 offre l'avantage d'utiliser ce procédé de connexion par laser, en rendant le conducteur (31) compatible avec ce procédé. Par exemple, le conducteur (31) peut être métallique ou dopé avec des dopants de même type que la région de source ou de drain adjacente. En cas d'utilisation du faisceau laser (21) selon le procédé décrit en référence à la figure 3, ce faisceau serait évidemment placé pour chevaucher entre un bord du conducteur (31) et l'élément conducteur correspondant à relier. Ceci peut être aussi le cas pour la liaison du conducteur (23).

## Revendications

1. Procédé de commande de l'état de conduction d'un transistor MOS (11) formé d'une grille (16) qui est isolée du substrat (12) d'une puce de circuits intégrés (10) par une couche diélectrique mince (17) et qui a des parties latérales recouvrant respectivement sur une distance d les régions de source (14) et de drain (15) dopées d'un type conductivité donné et incorporées dans ledit substrat (12) , consistant à former avec un faisceau laser une connexion électrique définitive dans ladite couche diélectrique mince entre ladite région comme premier conducteur et un second conducteur superposé fait d'un matériau métallique et/ou de silicium polycristallin dopé dudit type de conductivité, et à prendre comme second conducteur la partie latérale correspondante de la grille ou une partie d'un conducteur (31) relié à la grille, caractérisé en ce que la formation de la connexion consiste à faire chevaucher le faisceau laser (21) sur le second conducteur (16, 31) et sur une partie adjacente de ladite région et à ajuster la puissance du faisceau laser, son diamètre, le nombre et la durée d'impulsion de façon suffisante à créer la connexion (22) dans la couche diélectrique par des défauts définitifs d'isolation dans une zone située à l'aplomb du bord du second conducteur.

2. Procédé selon la revendication 1, caractérisé en ce qu'il consiste à former la connexion lorsque le substrat (12) est pourvu d'un réseau d'interconnexion (23, 29).

3. Procédé selon la revendication 2, caractérisé en ce que le réseau d'interconnexion porte une couche de passivation.

4. Procédé selon l'une des revendications 1 à 3, caractérisé en ce qu'il consiste à polariser la grille (16) avec le courant inverse de la diode (25) formée par l'interface du substrat (12) avec une région (24) du substrat (12), dopée et placée à potentiel flottant.

5. Procédé de programmation par laser d'un circuit formé sur une puce de circuits intégrés et incluant au moins un transistor MOS (11), caractérisé en ce qu'il consiste à commander l'état de conduction du transistor (11) en appliquant le procédé défini par l'une des revendications 1 à 4.

6. Procédé selon la revendication 5, caractérisé en ce que le circuit est une cellule de mémoire morte programmable.

## Patentansprüche

1. Verfahren zum Steuern des Leitungszustandes eines MOS-Transistors (11), welcher von einem Gate (16) gebildet ist, das von dem Substrat (12) eines IC-Chips (10) durch eine dünne dielektrische Schicht (17) isoliert ist und das Seitenteile aufweist, die jeweils über eine Distanz d die mit einem vorgegebenen Leitfähigkeitstyp dotierten und in dem Substrat (12) eingefügten Source- (14) und Drainzonen (15) bedecken, welches darauf beruht, mit einem Laserstrahl eine definitive elektrische Verbindung in der dünnen dielektrischen Schicht zwischen der besagten Zone als erstem Leiter und einem zweiten, darüberliegenden, aus einem metallischen Material und/oder mit dem besagten Leitfähigkeitstyp dotiertem polykristallinem Silizium gefertigten Leiter zu bilden und als zweiten Leiter das entsprechende Seitenteil des Gates oder einen Teil eines mit dem Gate verbundenen Leiters (31) zu verwenden, dadurch gekennzeichnet, daß die Realisierung der Verbindung darauf beruht, daß der Laserstrahl (21) den zweiten Leiter (16, 31) und einen angrenzenden Teil der Zone überschneidet und daß die Leistung des Laserstrahls, sein Durchmesser, die Impulsanzahl sowie die Impulsdauer derart eingestellt werden, daß sie groß genug sind, um die Verbindung (22) in der dielektrischen Schicht durch definitive Isolationsfehler in einer senkrecht unter dem Rand des zweiten Leiters angeordneten Zone zu realisieren.

2. Verfahren nach Anspruch 1, dadurch gekennzeichnet, daß es darauf beruht, die Verbindung zu bilden, wenn das Substrat (12) mit einem Verbindungsnetz (23, 29) versehen ist.

3. Verfahren nach Anspruch 2, dadurch gekennzeichnet, daß das Verbindungsnetz eine Passivierungsschicht trägt.

4. Verfahren nach einem der Ansprüche 1 bis 3, dadurch gekennzeichnet, daß es darauf beruht, das Gate (16) mit dem Rückwärtsstrom der Diode (25) vorzuspannen, welche von der Grenzfläche zwischen dem Substrat (12) und einer dotierten und auf Schwebepotential gesetzten Zone (24) des Substrats (12) gebildet ist.

5. Verfahren zur Laserprogrammierung einer auf einem IC-Chip gebildeten und wenigstens einen MOS-Transistor (11) enthaltenden Schaltung, dadurch gekennzeichnet, daß es darauf beruht, den Leitungszustand des Transistors (11) durch Anwendung des von einem der Ansprüche 1 bis 4 definierten Verfahrens zu steuern.

6. Verfahren nach Anspruch 5, dadurch gekennzeichnet, daß die Schaltung eine programmierbare Festwertspeicherzelle ist.

## Claims

1. A process for controlling the conduction state of a MOS transistor (11) formed of a gate (16) that is insulated from the substrate (12) of an integrated circuit chip (10) by a thin dielectric layer (17) and that has lateral portions overlapping respectively by a distance d the doped source (14) and drain (15) regions of a given conductivity type and incorporated in said substrate (12), consisting in forming with a laser beam a definitive electrical connection in said thin dielectric layer between said region as a first conductor and a second superimposed conductor made of a metallic material and/or of doped polycrystalline silicon of said conductivity type, and in taking as a second conductor the corresponding lateral portion of the gate or a portion of a conductor (31) connected to the gate, characterised in that the formation of the connection consists in causing the laser beam (21) to span the second conductor (16, 31) and an adjacent portion of said region and in adjusting the power of the laser beam, its diameter, and the number and duration of pulses sufficiently to create the connection (22) in the dielectric layer by definitive absences of insulation in an area located directly over the edge of the second conductor.

2. A process according to Claim 1, characterised in that it consists in forming the connection when the substrate (12) is provided with an interconnection network (23, 29).

3. A process according to Claim 2, characterised in that the interconnection network has a passivation layer.

4. A process according to one of Claims 1 to 3, characterised in that it consists in polarising the gate (16) with the inverse current of the diode (25) formed by the interface of the substrate (12) with a region (24) of the substrate(12), doped and positioned with floating potential.

5. A process for programming by laser a circuit formed on an integrated circuit chip including at least one MOS transistor (11), characterised in that it consists in controlling the conduction state of the transistor (11) by applying the process defined by one of Claims 1 to 4.

6. A process according to Claim 5, characterised in that the circuit is a programmable read-only memory cell.
